# EUROPEAN PATENT SPECIFICATION

(11) **EP 3 499 649 B1**
(45) Date of publication and mention of the grant of the patent: **04.09.2024**
(21) Application number: 17207187.0
(22) Date of filing: 14.12.2017
(51) Int. Cl.: H05K 3/30, H05K 7/14, H01L 23/04, H01L 23/053, H01L 23/373, H01L 25/16, H01L 23/498, H01L 25/07, H01R 12/58, H01R 12/70

(54) **POWER SEMICONDUCTOR MODULE ARRANGEMENT**
LEISTUNGSHALBLEITERMODULANORDNUNG
AGENCEMENT D'UN MODULE DE SEMI-CONDUCTEUR DE PUISSANCE

(43) Date of publication of application: 19.06.2019
(73) Proprietor: Infineon Technologies AG, 85579 Neubiberg (DE)
(72) Inventor: Krugmann, Jens, 33102 Paderborn (DE); Nottelmann, Regina, 59505 Bad Sassendorf (DE)
(74) Representative: Westphal, Mussgnug & Partner, Patentanwälte mbB

(56) References cited:
- WO-A1-2007/144428
- US-A1- 2010 149 774
- US-A1- 2013 343 017
- US-A1- 2014 199 861
- US-A1- 2016 336 245

## Description

### TECHNICAL FIELD

The instant disclosure relates to a power semiconductor module arrangement.

### BACKGROUND

Power semiconductor module arrangements often include a substrate within a housing. The substrate usually comprises a substrate layer (e.g., a ceramic layer), a first metallization layer deposited on a first side of the substrate layer and a second metallization layer deposited on a second side of the substrate layer. A semiconductor arrangement including one or more controllable semiconductor elements (e.g., two IGBTs in a half-bridge configuration) may be arranged on a substrate. One or more contact elements, which allow for contacting such a semiconductor arrangement from outside the housing, are usually provided. Power semiconductor modules are known, where the contact elements are arranged on the substrate and protrude in a direction that is essentially perpendicular to the main surface of the substrate through a cover of the housing. The section of the contact elements which protrudes out of the housing may be mechanically and electrically coupled to a printed circuit board. Usually, the printed circuit board comprises through holes and the contact elements are inserted through the respective through holes. Often, the power semiconductor module with the semiconductor arrangement including the contact elements is prefabricated and customers may mount their own customized printed circuit boards to the prefabricated power semiconductor module. When mounting a printed circuit board to the power semiconductor module, great forces may be exerted on the contact elements when the printed circuit board is not accurately aligned with the contact elements. This may lead to damages of the contact elements and of the power semiconductor module.

Document US 2014/0199861 A1 discloses an electrical module including a housing, at least one electrical component mounted within the housing and an electrical press-fit contact. The electrical press-fit contact is located in part within the housing and has a press fit portion and a stop portion at its distal end and a mounting portion at its proximal end. The mounting portion is electrically coupled to the electrical component. The press-fit portion is located exterior of the housing such that the stop portion is able to block movement of the press-fit section into the housing when a press-in force is introduced onto the press-in contact to press the press-fit contact into the housing.

Document US 2010/0149774 A1 discloses a semiconductor device including a terminal case containing a semiconductor element, a plurality of pin terminals of equal length mounted in the terminal case and electrically connected to the semiconductor element, the plurality of pin terminals projecting outward from a predetermined surface of the terminal case in the same direction, and at least one protruding pin terminal mounted in the terminal case and projecting outward from the predetermined surface of the terminal case in the same direction farther than the plurality of pin terminals.

Document US 2016/0336245 A1 discloses a power semiconductor device including: an outer case; at least one press-fit terminal buried in a top surface of the outer case; and a plurality of supporting portions formed so as to protrude from the top surface of the outer case. A top end of the press-fit terminal protrudes more than top surfaces of the supporting portions from the top surface of the outer case.

Document WO 2007/144428 A1 discloses an electrical connector having a group of contacts comprising a plurality of signal contacts and a plurality of ground contacts, to be press-fit connected to through holes on a PCB, such that the plurality of signal contacts and plurality of ground contacts have bulge portions of larger lateral dimension than the through holes, and the bulge portions have openings in a direction lateral to a direction of insertion of the contacts, and at least one of the ground contacts has an extension portion extending from the bulge portion thereof.

Document US 2013/343017 A1 discloses a circuit housing having a printed circuit board and a circuit and holes in which peg-like positioning elements projecting away from the housing engage for positioning the PCB relative to the housing, at least one positioning element projecting without play into one circular hole, another positioning element, accommodated in another hole, having spreading fingers separated from one another by at least one recess, projecting into/through the further hole, elastically transverse to the direction of an imaginary connecting line of the holes and a cross-section such that a) in the direction of the imaginary connecting line, there is play between the spreading fingers and a radially inner circumferential surface of the another hole on both sides, but b) the spreading fingers make contact by their diametrically opposite side faces with the inner face of the another hole perpendicular to the connecting line without play only along a contact line/point.

There is a need for a power semiconductor module arrangement that provides an increased mechanical robustness to prevent damages, and a method for producing the same.

### SUMMARY

A power semiconductor module arrangement includes a housing comprising sidewalls and a substrate arranged in the housing, the substrate including a dielectric insulation layer, a first metallization layer arranged on a first side of the dielectric insulation layer, and a second metallization layer arranged on a second side of the dielectric insulation layer, wherein the dielectric insulation layer is disposed between the first and the second metallization layer. The arrangement further includes at least one semiconductor body mounted on a first surface of the first metallization layer which faces away from the dielectric insulation layer, a contact element that is mechanically and electrically connected to the substrate, wherein the contact element extends from the substrate through the interior of the housing to the outside of the housing in a direction perpendicular to the first surface, and exactly two or exactly three guiding elements coupled to the housing. If a printed circuit board comprising first and second through holes is mounted to the power semiconductor module arrangement, the exactly two or exactly three guiding elements are configured to be inserted into the second through holes, thereby serving as an insertion aid that accurately aligns the printed circuit board and the contact element, and the exactly two or exactly three guiding elements are further configured to securely hold the printed circuit board in a final mounting position on the power semiconductor module arrangement and prevent any vertical and horizontal movements of the printed circuit board when the printed circuit board is arranged in its final mounting position. A first guiding element of the exactly two or exactly three guiding elements, when the printed circuit board is arranged in its final mounting position, is configured to prevent a movement of the printed circuit board primarily in a first horizontal direction, a second guiding element of the exactly two or exactly three guiding elements, when the printed circuit board is arranged in its final mounting position, is configured to prevent a movement of the printed circuit board primarily in a second horizontal direction that is perpendicular to the first horizontal direction, wherein the horizontal directions are parallel to the first surface of the first metallization layer. Each guiding element of the exactly two or exactly three guiding elements has a first length and a width, wherein the first length is greater than the width. The contact element has a first end coupled to the substrate and a second end protruding out of the housing. Each guiding element of the exactly two or exactly three guiding elements has a first end coupled to the housing and a second end constituting a farthest end of the guiding element from the housing, and a first distance between the first surface and the second end of each guiding element of the exactly two or exactly three guiding elements is greater than a second distance between the first surface and the second end of the contact element.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a conventional power semiconductor module arrangement.
Figure 2 is a cross-sectional view of a section of an exemplary power semiconductor module arrangement in accordance with the claimed invention.
Figure 3, including Figures 3A and 3B, schematically illustrates a press-fit connectior in accordance with the claimed invention.
Figure 4 is a cross-sectional view of an example of a power semiconductor module arrangement in accordance with the claimed invention.
Figure 5 is a diagonal view of an example of a power semiconductor module arrangement not falling within the scope of the claimed subject-matter but useful for the understanding thereof.
Figure 6, including Figures 6A to 6C, schematically illustrates top views of exemplary power semiconductor modules not falling within the scope of the claimed subject-matter but useful for the understanding thereof.
[0012] Figure 7, including Figures 7A and 7B, schematically illustrates the dimensions of a guiding element in accordance with the claimed invention.
Figure 8, including Figures 8A and 8B, schematically illustrates further top views of exemplary power semiconductor modules in accordance with the claimed invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

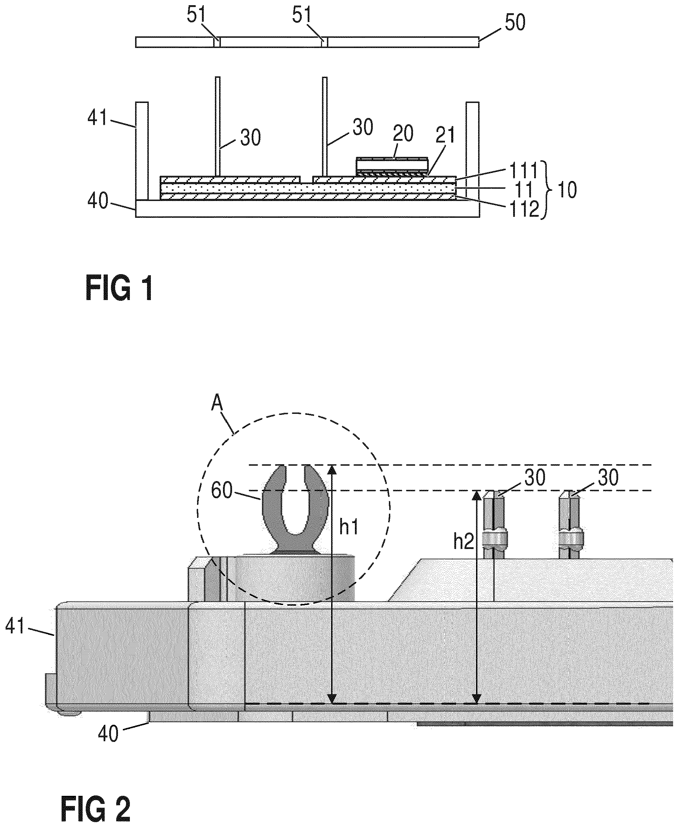

Referring to Figure 1, a conventional power semiconductor module arrangement is illustrated. The power semiconductor module arrangement includes a substrate 10. The substrate 10 includes a dielectric insulation layer 11, a (structured) first metallization layer 111 arranged on a first side of the dielectric insulation layer 11, and a second metallization layer 112 arranged on a second side of the dielectric insulation layer 11. The dielectric insulation layer 11 is disposed between the first and the second metallization layer 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminium oxide; aluminium nitride; zirconium oxide; silicon nitride; boron nitride; or any other dielectric ceramic. The substrate 10 may be, e.g., a Direct Copper Bonding (DCB) substrate, a Direct Aluminium Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, A1N, or BrN and may have a diameter of between about 1µm and about 50µm. The first metallization layer 111 of an IMS may be a comparably thin copper layer (e.g., thickness of between 35µm and 140µm), and the second metallization layer 112 may be a comparably thick aluminium or copper layer (e.g., thickness of between 0.6mm and 2.0mm), for example. The substrate 10, however, may also be a conventional printed circuit board (PCB) having a non-ceramic dielectric insulation layer 11. For instance, a non-ceramic dielectric insulation layer 11 may consist of or include a cured resin.

One or more semiconductor bodies 20 may be arranged on the substrate 10. In particular, the one or more semiconductor bodies 20 may be arranged on a first surface of the first metallization layer 111 which faces away from the dielectric insulation layer 11. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only one semiconductor body 20 is exemplarily illustrated. The one or more semiconductor bodies 20 may be electrically and mechanically connected to the main substrate 10 by an electrically conductive connection layer 21. Such an electrically conductive connection layer 21 may be a solder layer, a layer of an electrically conductive adhesive, or a layer of a sintered metal powder (e.g., a sintered silver powder), for example.

The second metallization layer 112 of the semiconductor substrate 10 in Figure 1 is a continuous layer. The first metallization layer 111 is a structured layer in the example illustrated in Figure 1. "Structured layer" in this context means that the first metallization layer 111 is not a continuous layer, but includes recesses between different sections of the layer. Such a recess is schematically illustrated in Figure 1. The first metallization layer 111 in this example includes two different sections. Different semiconductor bodies 20 may be mounted to the same or to different sections of the first metallization layer 111. There may also be sections of the first metallization layer 111 with no semiconductor bodies 20 mounted thereon. Different sections of the first metallization layer 111 may have no electrical connection or may be electrically connected to one or more other sections.

The substrate 10 may be arranged on a base plate 40, for example. In some semiconductor module arrangements (not illustrated), more than one substrate 10 is arranged on the same base plate 40. The substrate 10 may further be arranged in a housing 41 to form a power semiconductor module. The housing 41 may include sidewalls, as is schematically illustrated in Figure 1, with the base plate 40 forming a bottom of the housing 41. However, it is also possible that the housing 41 comprises sidewalls and a bottom, and the base plate 40 with the semiconductor substrate(s) 10 mounted thereon is arranged within the housing 41 (not illustrated). The housing 41 may further comprise a cover.

In order to facilitate an electrical connection between different sections of the first metallization layer 111, between different semiconductor bodies 20 and/or between any other elements and components arranged on the first metallization layer 111, as well as with external components outside the housing 40 (e.g., a printed circuit board), the power semiconductor module arrangement includes at least one contact element 30. The at least one contact element 30 is arranged on the substrate 10. Generally, the contact element 30 is arranged on the same surface (here: first surface of the first metallization layer 111) as the semiconductor bodies 20. The contact element 30 may be a pin or a wire, for example. The contact element 30 may consist of or include an electrically conductive material such as a metal or metal alloy. For example, the contact element 30 may consist of or include copper. The contact element 30 is connected to the substrate 10 by means of a connecting element (not illustrated). The connecting element may comprise a solder layer, an electrically conductive adhesive, a layer of a sintered metal powder, or a sleeve or rivet, for example. Generally speaking, the connecting element is configured to attach and electrically connect the contact element 30 to the substrate 10. The connecting element may comprise a tubular part (such as, e.g., a hollow bushing) that is configured to fit over and encompass a first end of the contact element 30. This means that a first end of the contact element 30 may be inserted into the connecting element. The connecting elements mentioned above, however, are only examples. The contact elements 30 may be mechanically and electrically connected to the substrate 10 in any other suitable way.

The contact element 30 protrudes from the substrate 10 through the inside of the housing 41 and through an opening in the cover of the housing 41 (if applicable) such that a second end of the contact element 30 protrudes to the outside of the housing 41. In this way, the contact element 30 may be electrically contacted from the outside of the housing 41. For example, the second ends of the contact elements 30 may be connected to a printed circuit board 50. The printed circuit board 50 comprises through holes 51 and the contact elements 30 are inserted into the through holes 51 of the printed circuit board 50. The printed circuit board 50 may comprise conducting tracks (not illustrated) and a contact element 30 may be electrically coupled to one or more other contact elements 30 by means of one or more conducting tracks. In this way, an electrical connection may be provided between different sections of the first metallization layer 111, between different semiconductor bodies 20, and/or between any other components arranged on the substrate 10 or on other substrates within the same housing 41.

The power semiconductor module arrangement usually is prefabricated. The printed circuit board 50, however, is generally customer-specific and is attached to the power semiconductor module arrangement at a later stage. A printed circuit board 50 needs to match the semiconductor arrangement and, in particular, the positions of the contact elements 30. In particular, the positions of the through holes 51 of the printed circuit board 50 need to exactly match the positions of the contact elements 30 such that the contact elements 30 may be easily inserted into the through holes 51. Therefore, the printed circuit board 50 needs to be accurately aligned with the contact elements 30, before introducing the contact elements 30 into the through holes 51. Rather high forces may be exerted to the contact elements 30 when the printed circuit board 50 is not accurately aligned with the contact elements 30. These forces may reduce the mechanical stability of the contact elements 30. For example, the electrical connections between the contact elements 30 and the connecting elements/the substrate 10 or between the contact elements 30 and the printed circuit board 50 may have to withstand great forces and may be damaged during the mounting process. This may adversely influence the operation of the power semiconductor module arrangement. Such problems may generally arise in connection with any kind of connection (e.g., soldered connections, press-fit connections). However, this may be particularly problematic in connection with press-fit connections.

After arranging a printed circuit board 50 on the power semiconductor module arrangement, the printed circuit board 50 needs to be permanently fixed to the power semiconductor module arrangement. Therefore, a permanent mechanical connection is usually provided between the housing 41 and the printed circuit board 50. In this way, the printed circuit board 50 may form a cover for the housing 41. By permanently mounting the printed circuit board 50 to the housing 41, any movements of the printed circuit board 50 are prevented. Movements of the printed circuit board 50 would exert unwanted forces on the contact elements 30 which might reduce the mechanical stability of the contact elements 30.

The present invention aims at decreasing the mechanical stress on the contact elements 30 during the mounting of the printed circuit board as well as after mounting the printed circuit board 50 to the power semiconductor module arrangement. The power semiconductor module arrangement, therefore, provides an adequate permanent mechanical connection between the printed circuit board 50 and the housing 41.

As is schematically illustrated in Figure 2, the power semiconductor module arrangement comprises guiding elements 60. The guiding elements 60 are configured to accurately position a printed circuit board 50 before inserting the contact elements 30 into the through holes 51 of the printed circuit board 50. The guiding elements 60 are mechanically coupled to the housing 41. For example, the guiding elements 60 may be coupled to the sidewalls or to an upper surface of the housing 41. The guiding elements 60 may be coupled to the housing 41 in any suitable way. For example, the guiding elements 60 may be glued to the housing, clamping elements (not illustrated) may be used to fixate the guiding elements 60 to the housing 41, or the guiding elements 60 may be partly molded into the housing 41. It is also possible that the guiding elements 60 are integrally formed with the housing 41. The guiding elements 60 have a first end and a second end. The first end of the guiding element 60 is a lower end arranged adjacent to the housing 41. The second end is an upper end that constitutes a farthest end of the guiding element from the substrate 10. A first distance h1 between the substrate 10 (e.g., first surface of the first metallization layer 111) and the upper end of the guiding element 60 is greater than a second distance h2 between the substrate 10 (e.g., first surface of the first metallization layer 111) and the upper end of the contact elements 30. The upper end of the contact elements 30 is the end which protrudes out of the housing 41 and which constitutes the farthest end of the contact element 30 from the substrate 10. The upper ends of the contact elements 30 which protrude out of the housing 41 are also schematically illustrated in Figure 2.

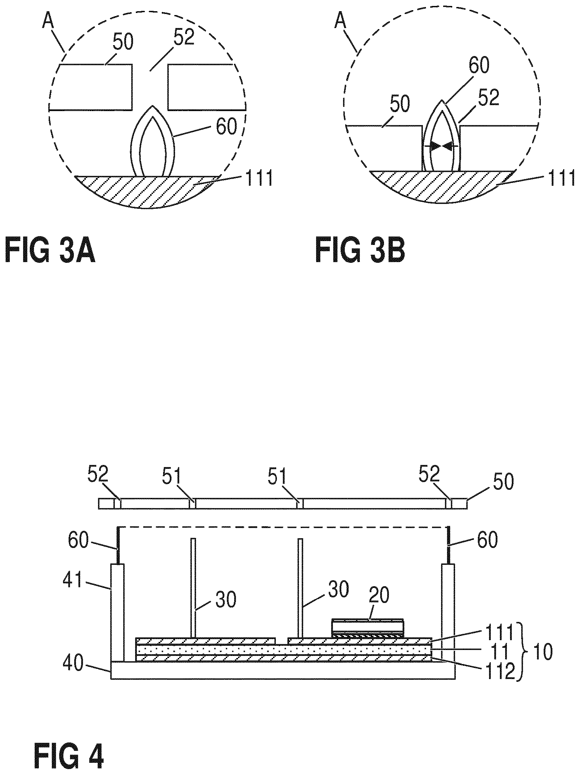

As is schematically illustrated in Figure 4, the printed circuit board 50 may comprise second through holes 52. When mounting the printed circuit board 50 to the housing, the guiding elements 60 are inserted into the second through holes 52. As the guiding elements 60 stand out further from the housing 41 than the contact elements 30 (h1 > h2), the printed circuit board 50 first contacts the guiding elements 60 when lowering the printed circuit board 50 onto the power semiconductor module arrangement. Only after the guiding elements 60 have been inserted into the second through holes 52 and the printed circuit board 50 is further lowered in the direction of the substrate 10, the printed circuit board 50 subsequently also contacts the contact elements 30. When the printed circuit board 50 is thrusted on the guiding elements 60 (guiding elements 60 inserted into second through holes 52), it can only perform vertical movements in a direction perpendicular to a top surface of the semiconductor substrate 10. A top surface of the semiconductor substrate 10 is a surface on which the semiconductor bodies 20 are arranged and which faces away from the base plate 40 (e.g., first surface of the first metallization layer 111). The guiding elements 60, however, prevent any horizontal movements of the printed circuit board 50. Horizontal movements in this context are movements in a direction that is essentially parallel to the top surface of the semiconductor substrate 10 (e.g., first surface of the first metallization layer 111).

When the guiding elements 60 have been inserted into the second through holes 52, the printed circuit board 50 and the first through holes 51 are accurately aligned with the contact elements 30. The contact elements 30, therefore, may be easily inserted into the through holes 51. The guiding elements 60, however, are not only configured to accurately align the printed circuit board 50. The guiding elements 60 are further configured to form a permanent connection with the printed circuit board 50 and to hold the printed circuit board 50 in place when the printed circuit board 50 is in its final mounting position. This is, the guiding elements 60 further prevent any vertical movements of the printed circuit board 50, once the printed circuit board 50 has been brought in its final mounting position.

For example, the guiding elements 60 may include or may be so-called press-fit pins and the guiding element 60 and the second through holes 52 may form press-fit connections when the guiding elements 60 are fully inserted into the second through holes 52. The guiding elements 60 may include press-fit pins at their second ends, for example, which face away from the housing 41. This is exemplarily illustrated in Figure 3, where Figure 3A schematically illustrates the press-fit pin (guiding element 60) and the corresponding counterpart (second through hole 52) in a non-assembled state, and Figure 3B schematically illustrates the press-fit pin and the corresponding counterpart in an assembled state. The second through holes 52 may form an appropriate counterpart for the press-fit pin of the guiding element 60. While not connected to the counterpart, a press-fit pin has a larger length than its counterpart. The length of the press-fit pin is a length in a direction parallel to the top surface of the semiconductor substrate 10. During the press-in process, the press-fit pin is pushed into the counterpart. This results in a plastic deformation of the press-fit pin. When inserted into the counterpart, the length of the press-fit pin is reduced. Only small insertion forces are generally necessary with high holding forces at the same time. The press-fit pin and the counterpart, after inserting the press-fit pin, are firmly attached to each other. The reduced length of the press-fit pin results in a force which counteracts the compression of the press-fit pin. The guiding elements 60, therefore, may not be easily detached from the second through holes 52. However, press-fit connections formed between the guiding elements 60 and the corresponding second through holes 52 are only an example. Any other suitable connections between the guiding elements 60 and the printed circuit board 50 are also possible.

As the guiding elements 60 are not only configured to accurately align the printed circuit board 50 and the contact elements 30, but also to firmly attach the printed circuit board 50 to the power semiconductor module arrangement, no further components are needed to hold the printed circuit board 50 in its mounting position. This simplifies the mounting process and reduces the overall costs of the power semiconductor module arrangement.

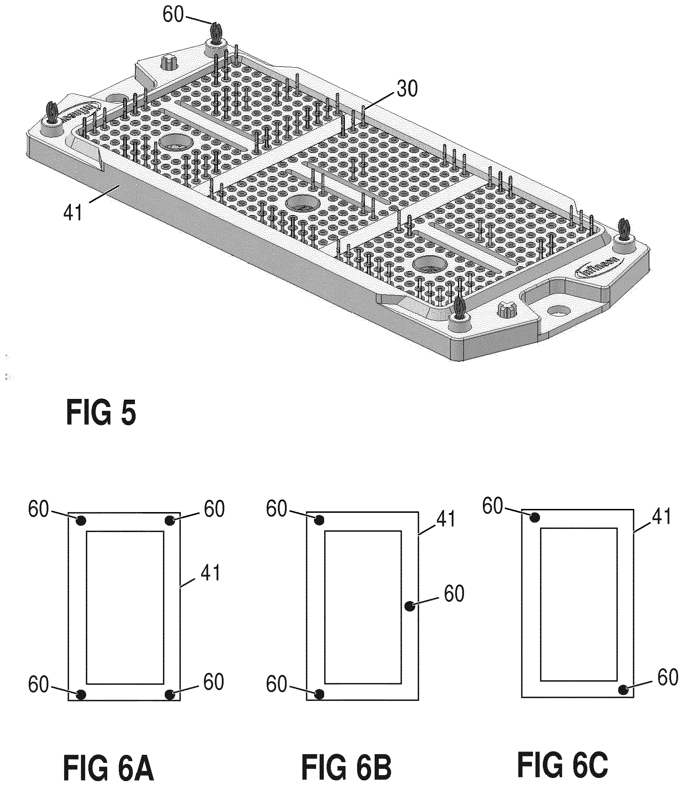

Figure 5 schematically illustrates a diagonal view of an example of a power semiconductor module arrangement not falling within the scope of the claimed subject-matter but useful for the understanding thereof. In Figure 5, the housing 41 of the power semiconductor module arrangement is schematically illustrated as well as the contact elements 30 protruding therefrom. The power semiconductor module arrangement in this example includes four guiding elements 60. The housing 41 has a rectangular form and each of the guiding elements 60 is arranged in one corner of the housing 41. This, however, is only an example. The guiding elements 60 may be arranged in different positions and at different distances from each other. It is also possible that the power semiconductor module arrangement comprises less than four guiding elements 60. Further, it is also possible that the power semiconductor module arrangement comprises more than four guiding elements 60. However, the more guiding elements 60 are provided, the higher the costs of the power semiconductor module arrangement.

Figure 6A schematically illustrates a top view on the arrangement of Figure 5, where each of four guiding elements 60 is arranged in one corner of a rectangular housing 41. The positions of the guiding elements 60 are merely indicated by solid dots. According to a further example that is schematically illustrated in Figure 6B, the power semiconductor module arrangement may only comprise three guiding elements 60. According to an even further example that is schematically illustrated in Figure 6C, the power semiconductor module arrangement may only comprise two guiding elements 60. The positions of the guiding elements in Figures 6A to 6C are merely examples. The guiding elements 60 may be arranged in any other suitable formation and at any other suitable positions.

According to the claimed invention, one guiding element 60 prevents a horizontal movement of the printed circuit board 50 primarily in only one horizontal direction. Therefore, a first guiding element 60 is provided to prevent a horizontal movement primarily in a first horizontal direction x and a second guiding element 60 is provided to prevent a horizontal movement primarily in a second horizontal direction y, wherein the first horizontal direction x is perpendicular to the second horizontal direction y.

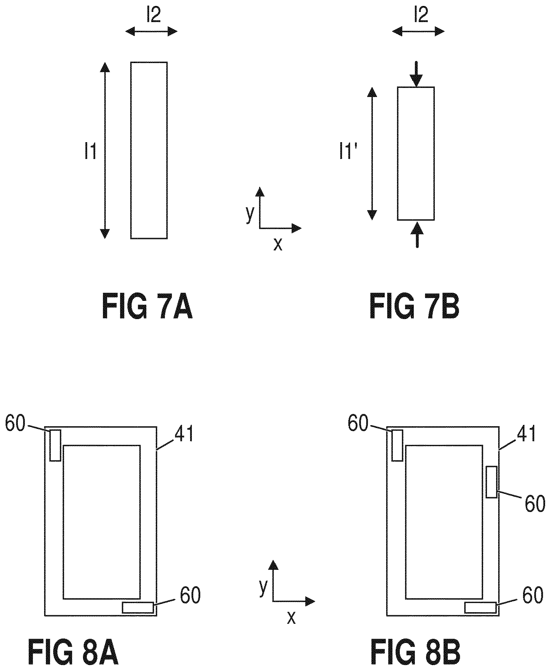

Figure 7 schematically illustrates top views of a press-fit pin. As can be seen in Figure 7A, which exemplarily illustrates a cross-sectional area of a press-fit pin in a non-assembled condition, the press-fit pin has a first length 11 in one horizontal direction, e.g., the second horizontal direction y, and has a second length l2 (or width) in a second horizontal direction, e.g., the first horizontal direction x, wherein the first length 11 is greater than the second length l2. For example, the first length 11 may be at least twice the second length l2, at least five times the second length l2, at least ten times the second length l2. When inserting the press-fit pin into the corresponding counterpart, the first length 11 of the press-fit pin is reduced to a reduced first length l1'. This is schematically illustrated in Figure 7B. The pressure that is exerted to the press-fit pin by the corresponding counterpart is schematically illustrated by means of arrows. In the example of Figure 7, the first length 11 and the reduced first length l1' extend in the second horizontal direction. Therefore, the press-fit pin may prevent a horizontal movement of the printed circuit board 50 primarily in the second horizontal direction y. If the first length 11 and the second length l1' extend in the first horizontal direction, the press-fit pin may prevent a horizontal movement of the printed circuit board 50 primarily in the first horizontal direction x.

As is schematically illustrated in Figure 8, the guiding elements 60 may be arranged on the housing 41 such that at least two of the guiding elements 60 extend in different horizontal directions. If one of the guiding elements 60 extends in the first horizontal direction x, for example, and at least one further guiding element 60 extends in the second horizontal direction y, as is schematically illustrated in Figures 8A and 8B, horizontal movements of a printed circuit board 50 are prevented in all horizontal directions. In such an arrangement, two guiding elements 60 are sufficient to hold the printed circuit board 50 in place, once the printed circuit board 50 is mounted to the housing 41. Further guiding elements 60 may be provided to even better prevent any unwanted movements of the printed circuit board 50. The printed circuit board is not illustrated in the examples of Figures 7 and 8.

Once the printed circuit board 50 is arranged in its final mounting position on the housing 41, the power semiconductor module arrangement with the printed circuit board 50 mounted thereon has a very high vibration strength. That is, the printed circuit board 50 is securely held in its mounting position even if the power semiconductor module arrangement is exposed to vibrations, shocks or any other impacts.

## Claims

1. A power semiconductor module arrangement comprising:
a housing (41) comprising sidewalls;
a substrate (10) arranged in the housing (41), the substrate (10) comprising a dielectric insulation layer (11), a first metallization layer (111) arranged on a first side of the dielectric insulation layer (11), and a second metallization layer (112) arranged on a second side of the dielectric insulation layer (11), wherein the dielectric insulation layer (11) is disposed between the first and the second metallization layer (111, 112);
at least one semiconductor body (20) mounted on a first surface of the first metallization layer (111) which faces away from the dielectric insulation layer (11);
a contact element (30) that is mechanically and electrically connected to the substrate (10), wherein the contact element (30) extends from the substrate (10) through the interior of the housing (41) to the outside of the housing (41) in a direction perpendicular to the first surface;
exactly two or exactly three guiding elements (60) coupled to the housing (41); and
a printed circuit board (50) comprising first and second through holes (51, 52), wherein
the exactly two or exactly three guiding elements (60) are configured to be inserted into the second through holes (52), thereby serving as an insertion aid that accurately aligns the printed circuit board (50) and the contact element (30), wherein the contact element (30) is configured to be inserted into the first through hole (51);
the exactly two or exactly three guiding elements (60) are further configured to securely hold the printed circuit board (50) in a final mounting position on the power semiconductor module arrangement and prevent any vertical and horizontal movements of the printed circuit board (50) when the printed circuit board (50) is arranged in its final mounting position;
a first guiding element (60) of the exactly two or exactly three guiding elements (60), when the printed circuit board (50) is arranged in its final mounting position, is configured to prevent a movement of the printed circuit board (50) primarily in a first horizontal direction (x);
a second guiding element (60) of the exactly two or exactly three guiding elements (60), when the printed circuit board (50) is arranged in its final mounting position, is configured to prevent a movement of the printed circuit board (50) primarily in a second horizontal direction (y) that is perpendicular to the first horizontal direction (x), wherein the horizontal directions are parallel to the first surface of the first metallization layer (111);
each guiding element (60) of the exactly two or exactly three guiding elements (60) has a first length (11) and a width (l2), wherein the first length (11) is greater than the width (l2);
the contact element (30) has a first end coupled to the substrate (10) and a second end protruding out of the housing (41);
each guiding element (60) of the exactly two or exactly three guiding elements (60) has a first end coupled to the housing (41) and a second end constituting a farthest end of the guiding element (60) from the housing (41); and
a first distance (h1) between the first surface and the second end of each guiding element (60) of the exactly two or exactly three guiding elements (60) is greater than a second distance (h2) between the first surface and the second end of the contact element (30).

2. The power semiconductor module arrangement of claim 1, wherein
each of the exactly two or exactly three guiding elements (60), at its second end, comprises a press-fit pin;
the second through holes (52) of the printed circuit board (50) form counterparts for the press-fit pins of the exactly two or exactly three guiding elements (60); and
the second ends of the exactly two or exactly three guiding elements (60) and the second through holes (52) of the printed circuit board (50) form a press-fit connection when the exactly two or exactly three guiding elements (60) are fully inserted into the second through holes (52).

3. The power semiconductor module arrangement of claim 1 or 2, wherein
the first guiding element (60) is arranged on the housing (41) such that its first length (11) extends in the first horizontal direction (x); and
the second guiding element (60) is arranged on the housing (41) such that its first length (11) extends perpendicular to the first length (11) of the first guiding element (60) in the second horizontal direction (y).

4. The power semiconductor module arrangement of any of the preceding claims, wherein at least one of the following applies:
the exactly two or exactly three guiding elements (60) are glued to the housing (41);
the power semiconductor module arrangement further comprises clamping elements configured to fixate the exactly two or exactly three guiding elements (60) to the housing (41);
the exactly two or exactly three guiding elements (60) are partly molded into the housing (41); and
the exactly two or exactly three guiding elements (60) are integrally formed with the housing (41).

5. The power semiconductor module arrangement of any of the preceding claims, wherein the contact element (30) is a pin or a wire.

6. The power semiconductor module arrangement of any of the preceding claims, further comprising a connecting element configured to mechanically and electrically couple the contact element (30) to the substrate (10).

7. The power semiconductor module arrangement of claim 6, wherein the connecting element comprises at least one of
a solder layer;
an electrically conductive adhesive;
a layer of a sintered metal powder;
a sleeve or rivet; and
a tubular part that is configured to fit over and encompass a first end of the contact element (30).

## Patentansprüche

1. Leistungshalbleitermodulanordnung, Folgendes umfassend:
ein Gehäuse (41), das Seitenwände umfasst,
ein Substrat (10), das in dem Gehäuse (41) angeordnet ist, wobei das Substrat (10) eine dielektrische Isolationsschicht (11), eine erste Metallisierungsschicht (111), die auf einer ersten Seite der dielektrischen Isolationsschicht (11) angeordnet ist, und eine zweite Metallisierungsschicht (112), die auf einer zweiten Seite der dielektrischen Isolationsschicht (11) angeordnet ist, umfasst, wobei die dielektrische Isolationsschicht (11) zwischen der ersten und der zweiten Metallisierungsschicht (111, 112) angeordnet ist,
mindestens einen Halbleiterkörper (20), der auf einer ersten Oberfläche der ersten Metallisierungsschicht (111) montiert ist, die von der dielektrischen Isolationsschicht (11) weg weist,
ein Kontaktelement (30), das mechanisch und elektrisch mit dem Substrat (10) verbunden ist, wobei sich das Kontaktelement (30) von dem Substrat (10) in einer zu der ersten Oberfläche rechtwinkligen Richtung durch das Innere des Gehäuses (41) nach außerhalb des Gehäuses (41) erstreckt,
genau zwei oder genau drei Führungselemente (60), die mit dem Gehäuse (41) gekoppelt sind, und
eine Leiterplatte (50), die erste und zweite Durchgangsöffnungen (51, 52) umfasst, wobei
die genau zwei oder genau drei Führungselemente (60) dazu ausgebildet sind, in die zweiten Durchgangsöffnungen (52) eingeführt zu werden, wodurch sie als eine Einsetzhilfe fungieren, welche die Leiterplatte (50) und das Kontaktelement (30) genau ausrichtet, wobei das Kontaktelement (30) dazu ausgebildet ist, in die erste Durchgangsöffnung (51) eingeführt zu werden,
die genau zwei oder genau drei Führungselemente (60) ferner dazu ausgebildet sind, die Leiterplatte (50) in einer endgültigen Montageposition auf der Leistungshalbleitermodulanordnung zu halten und jegliche vertikale und horizontale Bewegung der Leiterplatte (50) zu verhindern, wenn die Leiterplatte (50) in ihrer endgültigen Montageposition angeordnet ist,
ein erstes Führungselement (60) der genau zwei oder genau drei Führungselemente (60) dazu ausgebildet ist, eine Bewegung der Leiterplatte (50) vor allem in einer ersten horizontalen Richtung (x) zu verhindern, wenn die Leiterplatte (50) in ihrer endgültigen Montageposition angeordnet ist,
ein zweites Führungselement (60) der genau zwei oder genau drei Führungselemente (60) dazu ausgebildet ist, eine Bewegung der Leiterplatte (50) vor allem in einer zweiten horizontalen Richtung (y), die senkrecht zur ersten horizontalen Richtung (x) liegt, zu verhindern, wenn die Leiterplatte (50) in ihrer endgültigen Montageposition angeordnet ist, wobei die horizontalen Richtungen parallel zur ersten Oberfläche der ersten Metallisierungsschicht (111) liegen,
jedes Führungselement (60) der genau zwei oder genau drei Führungselemente (60) eine erste Länge (11) und eine Breite (12) aufweist, wobei die erste Länge (11) größer als die Breite (l2) ist,
das Kontaktelement (30) ein erstes Ende aufweist, das mit dem Substrat (10) gekoppelt ist, und ein zweites Ende, das aus dem Gehäuse (41) hervorsteht,
jedes Führungselement (60) der genau zwei oder genau drei Führungselemente (60) ein erstes Ende aufweist, das mit dem Gehäuse (41) gekoppelt ist, und ein zweites Ende, welches ein am weitesten von dem Gehäuse (41) entferntes Ende des Führungselements (60) bildet,
eine erste Distanz (h1) zwischen der ersten Oberfläche und dem zweiten Ende des Führungselements (60) der genau zwei oder genau drei Führungselemente (60) größer als eine zweite Distanz (h2) zwischen der ersten Oberfläche und dem zweiten Ende des Kontaktelements (30) ist.

2. Leistungshalbleitermodulanordnung nach Anspruch 1, wobei:
jedes der genau zwei oder genau drei Führungselemente (60) an seinem zweiten Ende einen Presssitzstift umfasst,
die zweiten Durchgangsöffnungen (52) der Leiterplatte (50) Gegenstücke für die Presssitzstifte der genau zwei oder genau drei Führungselemente (60) bilden und
die zweiten Enden der genau zwei oder genau drei Führungselemente (60) und die zweiten Durchgangsöffnungen (52) der Leiterplatte (50) eine Presssitzverbindung bilden, wenn die genau zwei oder genau drei Führungselemente (60) vollständig in die zweite Durchgangsöffnungen (52) eingesetzt sind.

3. Leistungshalbleitermodulanordnung nach Anspruch 1 oder 2, wobei:
das erste Führungselement (60) derart an dem Gehäuse (41) angeordnet ist, dass sich seine erste Länge (l1) in der ersten horizontalen Richtung (x) erstreckt, und
das zweite Führungselement (60) derart in dem Gehäuse (41) angeordnet ist, dass sich seine Länge (l1) rechtwinklig zu der ersten Länge (l1) des ersten Führungselements (60) in der zweiten horizontalen Richtung (y) erstreckt.

4. Leistungshalbleitermodulanordnung nach einem der vorhergehenden Ansprüche, wobei mindestens eines der Folgenden gilt:
die genau zwei oder genau drei Führungselemente (60) sind an das Gehäuse (41) geklebt,
die Leistungshalbleitermodulanordnung umfasst ferner Klemmelemente, die dazu ausgebildet sind, die genau zwei oder genau drei Führungselemente (60) an dem Gehäuse (41) zu fixieren,
die genau zwei oder genau drei Führungselemente (60) sind teilweise in das Gehäuse (41) eingegossen und
die genau zwei oder genau drei Führungselemente (60) sind einstückig mit dem Gehäuse (41) gebildet.

5. Leistungshalbleitermodulanordnung nach einem der vorhergehenden Ansprüche, wobei das Kontaktelement (30) ein Stift oder ein Draht ist.

6. Leistungshalbleitermodulanordnung nach einem der vorhergehenden Ansprüche, ferner ein Verbindungselement umfassend, das dazu ausgebildet ist, das Kontaktelement (30) mechanisch und elektrisch mit dem Substrat (10) zu koppeln.

7. Leistungshalbleitermodulanordnung nach Anspruch 6, wobei das Verbindungselement mindestens eines der Folgenden umfasst:
eine Lotschicht,
einen elektrisch leitenden Haftstoff,
eine Schicht aus einem gesinterten Metallpulver,
eine Hülse oder eine Niete und
ein röhrenförmiges Teil, das dazu ausgebildet ist, über ein erstes Ende des Kontaktelements (30) zu passen und dieses zu umschließen.

## Revendications

1. Agencement de module à semiconducteur de puissance comprenant :
un boîtier (41) comprenant des parois latérales ;
un substrat (10) disposé dans le boîtier (41), le substrat (10) comprenant une couche (11) diélectrique isolante, une première couche (111) de métallisation disposée sur une première face de la couche (11) diélectrique isolante, et une deuxième couche (112) de métallisation disposée sur une seconde face de la couche (11) diélectrique isolante, dans lequel la couche (11) diélectrique isolante est disposée entre la première et la deuxième couches (111, 112) de métallisation, ;
au moins un corps (20) à semiconducteur monté sur une première surface de la première couche (111) de métallisation, qui est en face de la couche (11) diélectrique isolante en en étant loin ;
un élément (30) de contact, qui est relié mécaniquement et électriquement au substrat (10), dans lequel l'élément (30) de contact s'étend du substrat (10) à l'extérieur du boîtier (41) en passant à l'intérieur du boîtier (41) dans une direction perpendiculaire à la première surface ;
exactement deux ou exactement trois éléments (60) de guidage reliés au boîtier (41) ;
et
une plaquette (50) à circuit imprimé comprenant des premiers et deuxièmes trous (51, 52) traversants,
dans lequel
les exactement deux ou exactement trois éléments (60) de guidage sont configurés pour être insérés dans les deuxièmes trous (52) traversants, en servant ainsi d'une aide à l'insertion, qui aligne avec précision la plaquette (50) à circuit imprimé et l'élément (30) de contact, dans lequel l'élément (30) de contact est configuré pour être inséré dans le premier trou (51) traversant ;
les exactement deux ou exactement trois éléments (60) de guidage sont configurés en outre pour maintenir d'une manière fixe la plaquette (50) à circuit imprimé en une position finale de montage sur l'agencement de module à semiconducteur de puissance et empêcher tout mouvement vertical et horizontal de la plaquette (50) à circuit imprimé, lorsque la plaquette (50) à circuit imprimé est disposée dans sa position finale de montage ;
un premier élément (60) de guidage parmi les exactement deux ou exactement trois éléments (60) de guidage est configuré pour, lorsque la plaquette (50) à circuit imprimé est disposée dans sa position finale de montage, empêcher un mouvement de la plaquette (50) à circuit imprimé, en premier dans une première direction (x) horizontale ;
un deuxième élément (60) de guidage des exactement deux ou exactement trois éléments (60) de guidage est configuré pour, lorsque la plaquette (50) à circuit imprimé est disposée dans sa position finale de montage, empêcher un mouvement de la plaquette (50) à circuit en premier dans une deuxième direction (y) horizontale, qui est perpendiculaire à la première direction (x) horizontale, les directions horizontales étant parallèles à la première surface de la première couche (111) de métallisation ;
chaque élément (60) de guidage des exactement deux ou exactement trois éléments (60) de guidage a une première longueur (11) et une largeur (12), la première longueur (11) étant plus grande que la largeur (12) ;
l'élément (30) de contact a un premier bout relié au substrat (10) et un second bout faisant saillie du boîtier (41) ;
chaque élément (60) de guidage des exactement deux ou exactement trois éléments (60) de guidage a un premier bout relié au boîtier (41) et un second bout constituant un bout de l'élément (60) de guidage le plus loin du boîtier (41) ; et
une première distance (h1) entre la première surface et le deuxième bout de chaque élément (60) de guidage des exactement deux ou exactement trois éléments (60) de guidage est plus grande qu'une deuxième distance (h2) entre la première surface et le second bout de l'élément (30) de contact.

2. Agencement de module à semiconducteur de puissance suivant la revendication 1, dans lequel
chacun des exactement deux ou exactement trois éléments (60) de guidage comprend, à son second bout, une cheville à ajustement serré ;
les deuxièmes trous (52) traversants de la plaquette (50) à circuit imprimé forment des contreparties des chevilles à ajustement serré des exactement deux ou exactement trois éléments (60) de guidage ; et
les seconds bouts des exactement deux ou exactement trois éléments (60) de guidage et les deuxièmes trous (52) traversants de la plaquette (50) à circuit imprimé forment une connexion à ajustement serré, lorsque les exactement deux ou exactement trois éléments (60) de guidage sont insérés entièrement dans les deuxièmes trous (52) traversants.

3. Agencement de module à semiconducteur de puissance suivant la revendication 1 ou 2, dans lequel
le premier élément (60) de guidage est disposé dans le boîtier (41) de manière à ce que sa première longueur (l1) s'étende dans la première direction (x) horizontale ; et
le deuxième élément (60) de guidage est disposé dans le boîtier (41) de manière à ce que sa première longueur (l1) s'étende perpendiculairement à la première longueur (l1) du premier élément (60) de guidage dans la deuxième direction (y) horizontale.

4. Agencement de module à semiconducteur de puissance suivant l'une quelconque des revendications précédentes, dans lequel au moins l'un de ce qui suit s'applique :
les exactement deux ou exactement trois éléments (60) de guidage sont collés au boîtier (41) ;
l'agencement de module à semiconducteur de puissance comprend en outre des éléments de serrage configurés pour fixer les exactement deux ou exactement trois éléments (60) de guidage au boîtier (41) ;
les exactement deux ou exactement trois éléments (60) de guidage sont en partie moulés dans le boîtier (41) ; et
les exactement deux ou exactement trois éléments (60) de guidage sont formés d'une seule pièce avec le boîtier (41).

5. Agencement de module à semiconducteur de puissance suivant l'une quelconque des revendications précédentes, dans lequel l'élément (30) de contact est une broche ou un fil.

6. Agencement de module à semiconducteur de puissance suivant l'une quelconque des revendications précédentes, comprenant en outre un élément de liaison configuré pour relier mécaniquement et électriquement l'élément (30) de contact au substrat (10).

7. Agencement de module à semiconducteur de puissance suivant la revendication 6, dans lequel l'élément de liaison comprend au moins l'un de :
une couche de soudure ;
un adhésif conducteur de l'électricité ;
une couche de poudre métallique frittée ;
un manchon ou un rivet ; et
une partie tubulaire, qui est configurée pour s'adapter sur et entourer un premier bout de l'élément (30) de contact.
